# EUROPÄISCHE PATENTSCHRIFT

(11) **EP 1 261 755 B1**
(45) Veröffentlichungstag und Bekanntmachung des Hinweises auf die Patenterteilung: **08.09.2004**
(21) Anmeldenummer: 01915039.0
(22) Anmeldetag: 26.02.2001
(51) Int. Cl.: C23C 16/44, C23C 16/455, H01J 37/32, C30B 25/14

(54) **VORRICHTUNG UND VERFAHREN ZUR PLASMAGESTÜTZTEN OBERFLÄCHENBEHANDLUNG VON SUBSTRATEN IM VAKUUM**
DEVICE AND METHOD FOR CARRYING OUT PLASMA ENHANCED SURFACE TREATMENT OF SUBSTRATES IN A VACUUM
PROCEDE ET DISPOSITIF DE TRAITEMENT DE SURFACE DE SUBSTRATS SOUS VIDE, ASSISTE PAR PLASMA

(30) Priorität: 26.02.2000 DE 10010016
(43) Veröffentlichungstag der Anmeldung: 04.12.2002
(73) Patentinhaber: ROBERT BOSCH GMBH, 70442 Stuttgart (DE); FAP GmbH, 01217 Dresden (DE)
(72) Erfinder: WANKA, Harald, 72766 Reutlingen (DE); WEBER, Klaus, 01219 Dresden (DE); ROEHLECKE, Soeren, 01217 Dresden (DE); STEINKE, Olaff, 01465 Liegau-Augustusbad (DE); SCHADE, Klaus, 01468 Moritzburg (DE)
(86) Internationale Anmeldenummer: PCT/DE2001/000730
(87) Internationale Veröffentlichungsnummer: WO 2001/063003

(56) Entgegenhaltungen:
- WO-A-98/50606
- US-A- 4 592 307
- US-A- 4 901 668

## Beschreibung

Die Erfindung betrifft eine Vorrichtung und ein Verfahren zur plasmagestützten Oberflächenbehandlung von Substraten im Vakuum, wobei in Anlehnung an bekannte CVD-Verfahren gearbeitet wird. Sie kann insbesondere dann vorteilhaft eingesetzt werden, wenn hochreine, kontaminationsfreie Beschichtungen, wie sie u.a. in der Halbleitertechnik erforderlich sind, vorgenommen werden sollen.

Da für die Beschichtung von Substratoberflächen verschiedene reaktive bzw. aggressive Prozessgase verwendet werden, treten Probleme u.a. mit Restgasanteilen auf, die auch durch Spülen und intensives Evakuieren nicht vollständig aus Vakuumeinrichtungen entfernt werden können. Dieses Restgas kann zur Verunreinigung der abgeschiedenen Schichten führen, die deren Eigenschaften in unerwünschter Form beeinflussen können.

Es kann auch eine unerwünschte Ausbildung von Schichten im Inneren von Vakuumkammern auftreten.

Ein weiterer Nachteil tritt z.B. beim sogenannten Trockenätzen, zur Reinigung und Oberflächenvorbereitung der Substrate oder auch bei der Reinigung der Inneren Oberfläche eines Rezipienten einer Vakuumeinrichtung auf. Das zum Ätzen verwendete Prozessgas kann sich nach chemischen Reaktionen (z.B. Bildung von Ätzgasradikalen) unmittelbar an der Innenwandung oder an Zusatzeinrichtungen im Inneren von Vakuumkammern eine Schicht bildend absetzen. Eine solche Schichtbildung ist unerwünscht, da beispielsweise die Leistungs- oder Beschichtungsparameter negativ beeinflußt werden. Die Entfernung dieser Schichten ist mit erheblichem Aufwand verbunden.

Ausserdem können Teile der Vakuumeinrichtung durch aggressive Gase oder Reaktionsprodukte angegriffen und sogar zerstört werden, so dass auch Undichtheiten im System auftreten können.

Bei der Ausbildung von Beschichtungen auf Substraten als Siliciumlegierung wird häufig Monosilan als Si-Quelle verwendet. Da die unerwünschte Schichtbildung insbesondere an Teilen mit höheren Temperaturen gefördert wird, ist die thermische Zersetzung des Monosilans zu Silicium, die je nach Prozessgaszusammensetzung bei Temperaturen von ca. 250 bis 450 °C einsetzt, kritisch. Diese parasitär abgeschiedenen Schichten beeinflussen beispielsweise die optische Transparenz von Gläsern oder Fenstern und die Isoliereigenschaften von Keramiken.

Die genannten Probleme verstärken sich, je grösser die Vakuumkammerabmessungen sind.

Um diesen Effekten entgegen zu wirken wurde in US 4,798,739 vorgeschlagen eine Reaktionskammer zu verwenden, die in einer zusätzlichen Vakuumkammer angeordnet ist. Dabei sollen in Vakuum- und Reaktionskammer bestimmte Druckverhältnisse eingehalten werden, die einen Gasaustausch verhindern.

Dieser Effekt wird aber nur unbefriedigend erreicht, da die Reaktionskammer nicht hermetisch abschliessbar ist und trotz des zusätzlichen Aufwandes Restgas in die oder aus der Reaktionskammer gelangen kann.

Es ist daher Aufgabe der Erfindung, Möglichkeiten zur Oberflächenbehandlung von Substraten im Vakuum zu schaffen, mit denen homogene, kontaminationsfreie Schichten ausgebildet und die unerwünschte Beschichtung im Inneren von Vakuumbeschichtungsanlagen mit geringem Aufwand zu vermeiden.

Erfindungsgemäss wird diese Aufgabe mit den Merkmalen des Anspruchs 1 für eine Vorrichtung und den Merkmalen des Anspruchs 4 für ein Verfahren gelöst.

Vorteilhafte Ausgestaltungen und Weiterbildungen der Erfindung sind mit den in den untergeordneten Ansprüchen genannten Merkmalen erreichbar.

Die erfindungsgemässe Vorrichtung verwendet eine Vakuumkammer in der zusätzlich eine Reaktionskammer angeordnet ist. Beide Kammern müssen bei der erfindungsgemässen Lösung nicht 100 %-ig abgedichtet sein. Für die Vakuumkammer können herkömmliche, mit Gummidichtungen versehene Kammerteile mit relativ grossen Leckraten verwendet werden.

In der Reaktionskammer ist mindestens eine Elektrode zur Erzeugung eines Plasma mittels Glimmentladung und ein Substratträger mit Substrat (en) angeordnet. Ausserdem ist mindestens eine Zuführung für Prozessgas vorhanden. Die Vakuumkammer und Reaktionskammer sind mit getrennten Vakuumpumpen verbunden.

Die Reaktionskammer ist zusätzlich von einer Spülkammer umschlossen. Durch die Spülkammer wird über Anschlüsse ein gegenüber dem jeweiligen Prozessgas inertes Gas zu- und wieder abgeführt. Die Spülkammer kann die Reaktionskammer vollständig umschliessen. Es ist aber ausreichend, wenn die Spülkammer lediglich an Dichtflächen der Reaktionskammer angeordnet ist.

Da die Reaktionskammer ohnehin für den Austausch der verschiedenen Substrate in mindestens zwei Teilen ausgbildet sein muss, kann auch der Substratträger als ein Teil der Reaktionskammer dienen. Dabei ist der Substraträger aureichend gross dimensioniert und mit Dichtelementen versehen, so dass er einen abnehmbaren Teil der Reaktionskammerwand bilden kann.

Da es vorteilhaft ist, das Prozessgas nicht nur punktuell an einer Stelle in die Reaktionskammer einzuführen, ist die Prozessgaszuführung so ausgebildet und dimensioniert, dass das Prozessgas möglichst gleichmäßig verteilt in die Reaktionskammer einströmt.

Das Spülgas sollte mit einem Druck, der den Innendruck in der Reaktionskammer zumindest nicht übersteigt, durch die Spülkammer geführt werden. Eventuell aus der Reaktionskammer austretendes Prozessgas oder gasförmige Reaktionsprodukte werden dann mit dem Spülgas über die Spülgasabführung ausgetragen und die unerwünschte Beschichtung oder Ätzung innerhalb der Vakuumkammer werden so verhindert.

Ausserdem verhindert die zwischengeschaltete Spülkammer auch einen Eintritt von Restgas aus der Vakuumkammer in die Reaktionskammer während der Durchführung der Oberflächenbehandlung von Substraten.

In der Reaktionskammer können Substratoberflächen beschichtet oder an ihren Oberflächen durch Trockenätzung gereinigt oder modifiziert werden. Dementsprechend werden unterschiedliche Prozessgase verwendet. Zum Beschichten können beispielsweise Si₄, H₂, O₂, N₂, He, CO₂ oder Mischungen davon und als Ätzgas TiC1₄, SiCl₄, NF₃, SF₆, CF₄, CCl₄ eingesetzt werden. Selbstverständlich kann auch eine Innenreinigung der Reaktionskammer mittels Trockenätzen ohne Substrate durchgeführt werden.

Beispiele für geeignete inerte Gase, die durch die Spülkammer geführt werden können, sind H₂, He, Ar oder N₂. Das möglichst inerte Spülgas sollte in hochreiner Form eingesetzt werden und der Anteil an Verunreinigungen maximal unterhalb der maximalen Konzentration von Verunreinigungen im Prozessgas liegen.

Mit der Erfindung können verschiedene Oberflächenbehandlungen an Substraten im Vakuum durchgeführt werden, wobei durch die Entkopplung von Reaktions- und Vakuumkammer, ohne Beeinflussung des Prozesses, eine Verunreinigung des Prozessgases innerhalb der Reaktionskammer verhindert und ein Austritt von Prozessgas oder dessen Reaktionsprodukten in die Vakuumkammer vermieden werden. Dabei sollte Spülgas zumindest in der Zeit, in der die Oberflächenbehandlung, möglichst zeitlich darüber hinaus gehend durch die Spülkammer geführt werden.

Ausserdem sind die Anforderungen an die Abdichtung der einzelnen Elemente, die Fertigungsgenauigkeit und der Einfluss von thermisch bedingtem Verzug gegenüber herkömmlichen Lösungen stark reduziert.

Nachfolgend soll die Erfindung an Hand von Ausführungsbeispielen näher erläutert werden.

Dabei zeigt:

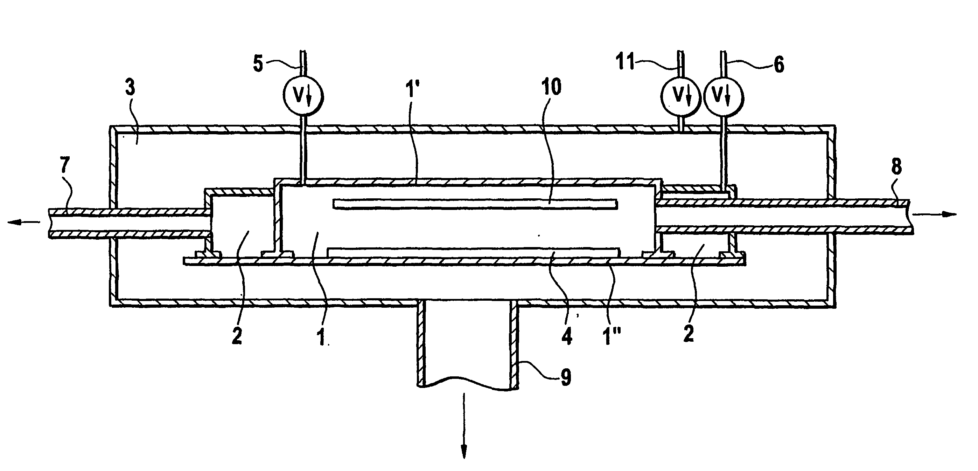

Figur 1 den schematischen Aufbau eines Beispiels einer erfindungsgemäßen Vorrichtung.

In Figur 1 ist ein Beispiel einer erfindungsgemässen Vorrichtung schematisch dargestellt. Dabei ist eine Reaktionskammer 1 innerhalb einer Vakkumkammer 3 angeordnet und an der Vakuumkammer 3 ein Anschluss 9 an eine Vakuumpumpe vorhanden.

Die Reaktionskammer 1 besteht aus zwei Teilen 1' und 1' ', die voneinander getrennt werden können, um den hier in der Reaktionskammer 1 angeordneten Substratträger 4 neu zu bestücken.

Durch die Prozessgaszuführung 5 kann ein für den jeweiligen Prozess geeignetes Prozessgas dosiert zugeführt werden.

Zur Erzeugung eines Plasma mittels Glimmentladung ist in der Reaktionskammer 1 eine Elektrode 10, die an eine nicht dargestellte Hochfrequenz- oder Gleichspannungsversorgung angeschlossen ist, angeordnet. Die Elektrode 10 weist gegenüber dem Substratträger 4 eine Potentialdifferenz auf.

An der Reaktionskammer 1 ist weiter ein Anschluss 8 für eine Vakuumpumpe (nicht dargestellt) vorhanden.

Um die Reaktionskammer 1 umlaufend ist im Bereich der Dichtflächen (Dichtungen sind in der Figur angedeutet) eine Spülkammer 2 angeordnet. In die Spülkammer 2 gelangt über die Zuführung 6 dosiert ein gegenüber dem Prozessgas inertes Gas als Spülgas, das über den Anschluss 7 wieder abgezogen wird. Der Spülgasdruck soll kleiner als der Innendruck in der Reaktionskammer 1 gehalten werden, ihn jedoch zumindest nicht überschreiten.

An der Vakuumkammer 3 ist bei diesem Beispiel ein zusätzlicher Anschluss 11 für die Zuführung von Spülgas in die Vakuumkammer angeschlossen.

In nicht dargestellter Form, kann der Substratträger 4 das Unterteil 1' ' der Reaktionskammer 1 ersetzen.

Das obere Teil 1' der Reaktionskammer 1 kann eine Abschirmung für die Elektrode 10 bilden. Der untere Teil 1' ' der Reaktionskammer 1 kann ebenfalls als Abschirmung ausgebildet sein, wenn auch der Substratträger 4 auf einem Potential liegt und als Elektrode geschaltet ist.

## Patentansprüche

1. Vorrichtung zur plasmagestützten Oberflächenbehandlung von Substraten im Vakuum, bei der mindestens eine Reaktionskammer in einer Vakuumkammer aufgenommen ist, an der Reaktionskammer Anschlüsse für die Zu- und Abführung von Prozessgas vorhanden sind und in der Reaktionskammer mindestens eine an eine Hochfrequenz- oder Gleichspannungsversorgung angeschlossene Elektrode angeordnet ist,
**dadurch gekennzeichnet, dass** die Reaktionskammer (1) zumindest an Dichtflächenbereichen von einer Spülkammer (2) innerhalb der Vakuumkammer (3) umschlossen ist; und an der Spülkammer (2) Anschlüsse für die Zu- und Abführung (6, 7) eines Spülgases vorhanden sind.

2. Vorrichtung nach Anspruch 1, **dadurch gekennzeichnet, dass** ein Substratträger (4) einen Teil der Wandung der Reaktionskammer (1) bildet.

3. Vorrichtung nach Anspruch 1 oder 2, **dadurch gekennzeichnet, dass** die Reaktionskammer (1) geteilt ist und die Teile (1', 1", 4) bei geschlossener Reaktionskammer (1) gegeneinander abgedichtet sind.

4. Verfahren zur plasmagestützten Oberflächenbehandlung von Substraten im Vakuum, bei dem mindestens ein Substrat in einer Reaktionskammer, die von einer Vakuumkammer umschlossen ist, angeordnet wird, in der Reaktionskammer bei Zuführung eines Prozessgases eine Gasentladung erzeugt und die Oberfläche des Substrates unterstützt durch die Gasentladung behandelt wird, **dadurch gekennzeichnet, dass** durch eine Spülkammer (2), die zumindest die Dichtflächenbereiche der Reaktionskammer (1) umschliesst, ein Spülgas geführt wird.

5. Verfahren nach Anspruch 4, **dadurch gekennzeichnet, dass** ein gegenüber dem Prozessgas inertes Spülgas verwendet wird.

6. Verfahren nach Anspruch 4 oder 5, **dadurch gekennzeichnet, dass** die Substratoberfläche mit Reaktionsprodukten des Prozessgases beschichtet wird.

7. Verfahren nach einem der Ansprüche 4 bis 6, **dadurch gekennzeichnet, dass** die Substratoberfläche mit dem Prozessgas durch Plasmaätzen bearbeitet wird.

8. Verfahren nach einem der Ansprüche 4 bis 7, **dadurch gekennzeichnet, dass** das Spülgas mit einem Druck ≤ dem Innendruck in der Reaktionskammer (1) durch die Spülkammer (2) geführt wird.

9. Verfahren nach einem der Ansprüche 4 bis 8, **dadurch gekennzeichnet, dass** als Spülgas Ar, H₂, N₂, CO₂ oder He verwendet wird.

10. Verfahren nach Anspruch 9, **dadurch gekennzeichnet, dass** das Spülgas in hochreiner Form mit maximaler Konzentration von Verunreinigungen, die ≤ der Verunreinigung des Prozessgases ist, verwendet wird.

11. Verfahren nach einem der Ansprüche 5 bis 10 , **dadurch gekennzeichnet, dass** das Prozessgas zur Plasma-Reinigung der Reaktionskammer (1) verwendet wird.

12. Verfahren nach einem der Ansprüche 5 bis 11, **dadurch gekennzeichnet, dass** als Prozessgas SiH₄, H₂, O₂, N₂O, CO₂, He, TiCl₄, SiCl₄, NF₃, SF₆, CF₄, CCl₄ oder Gemische davon verwendet werden.

## Claims

1. Device for the plasma-enhanced surface treatment of substrates in vacuo, in which at least one reaction chamber is accommodated in a vacuum chamber, connections for supplying and discharging process gas are present at the reaction chamber, and at least one electrode, which is connected to a radio frequency or DC voltage source, is arranged in the reaction chamber, **characterized in that** the reaction chamber (1), at least at sealing-surface regions, is surrounded by a purge chamber (2) inside the vacuum chamber (3); and connections for supplying and discharging (6, 7) a purge gas are present at the purge chamber (2).

2. Device according to Claim 1, **characterized in that** a substrate support (4) forms part of the wall of the reaction chamber (1).

3. Device according to Claim 1 or 2, **characterized in that** the reaction chamber (1) is split and the parts (1', 1", 4) are sealed with respect to one another when the reaction chamber (1) is closed.

4. Process for the plasma-enhanced surface treatment of substrates in vacuo, in which at least one substrate is arranged in a reaction chamber which is surrounded by a vacuum chamber, a gas discharge is generated in the reaction chamber with a process gas being supplied, and the surface of the substrate is treated with assistance from the gas discharge, **characterized in that** a purge gas is passed through a purge chamber (2) which surrounds at least the sealing-surface regions of the reaction chamber (1).

5. Process according to Claim 4; **characterized in that** a purge gas which is inert with respect to the process gas is used.

6. Process according to Claim 4 or 5, **characterized in that** the substrate surface is coated with reaction products of the process gas.

7. Process according to one of Claims 4 to 6, **characterized in that** the substrate surface is processed by plasma etching using the process gas.

8. Process according to one of Claims 4 to 7, **characterized in that** the purge gas is passed through the purge chamber (2) with a pressure which is less than or equal to the internal pressure in the reaction chamber (1).

9. Process according to one of Claims 4 to 8, **characterized in that** the purge gas used is Ar, H₂, N₂, CO₂ or He.

10. Process according to Claim 9, **characterized in that** the purge gas is used in high-purity form with a maximum concentration of impurities which is less than or equal to the impurity levels in the process gas.

11. Process according to one of Claims 5 to 10, **characterized in that** the process gas is used for plasma cleaning of the reaction chamber (1).

12. Process according to one of Claims 5 to 11, **characterized in that** the process gas used is SiH₄, H₂, O₂, N₂O, CO₂, He, TiCl₄, SiCl₄, NF₃, SF₆, CF₄, CCl₄ or mixtures thereof.

## Revendications

1. Dispositif de traitement de surface de substrats sous vide assisté par plasma, comportant au moins une chambre de réaction logée dans une chambre à vide, avec des raccords pour l'arrivée et l'évacuation de gaz de procédé prévus au niveau de la chambre de réaction, et avec au moins une électrode raccordée à une alimentation haute fréquence ou à une alimentation en tension continue, et disposée dans la chambre de réaction,
**caractérisé en ce que**
la chambre de réaction (1) est entourée au moins au niveau de zones de surfaces d'étanchéité par une chambre de rinçage (2) à l'intérieur de la chambre à vide (3), et des raccords pour l'arrivée et l'évacuation (6, 7) d'un gaz de rinçage sont présents au niveau de la chambre de rinçage (2).

2. Dispositif selon la revendication 1,
**caractérisé en ce qu'**
un support de substrat (4) forme une partie de la paroi de la chambre de réaction (1).

3. Dispositif selon la revendication 1 ou 2,
**caractérisé en ce que**
la chambre de réaction (1) est divisée et les parties (1', 1", 4) sont isolées les unes par rapport aux autres lorsque la chambre de réaction (1) est fermée.

4. Procédé de traitement de surface de substrats sous vide assisté par plasma, dans lequel au moins un substrat est disposé dans une chambre de réaction entourée par une chambre à vide, une décharge de gaz étant générée dans la chambre de réaction lors de l'arrivée d'un gaz de procédé et la surface du substrat étant traitée à l'aide de la décharge de gaz
**caractérisé en ce qu'**
un gaz de rinçage est amené à travers une chambre de rinçage (2), qui entoure au moins les zones de surfaces d'étanchéité de la chambre de réaction (1).

5. Procédé selon la revendication 4,
**caractérisé en ce qu'**
on utilise un gaz de rinçage inerte par rapport au gaz de procédé.

6. Procédé selon la revendication 4 ou 5,
**caractérisé en ce que**
la surface du substrat est recouverte avec des produits de la réaction du gaz de procédé.

7. Procédé selon l'une des revendications 4 à 6,
**caractérisé en ce que**
la surface du substrat est traitée avec le gaz de procédé par gravure par plasma.

8. Procédé selon l'une des revendications 4 à 7,
**caractérisé en ce que**
le gaz de rinçage est conduit par la chambre de rinçage (2) avec une pression inférieure ou égale à la pression intérieure dans la chambre de réaction (1).

9. Procédé selon l'une des revendications 4 à 8,
**caractérisé en ce que**
comme gaz de rinçage on utilise Ar, H₂, N₂, CO₂, ou He.

10. Procédé selon la revendication 9,
**caractérisé en ce que**
le gaz de rinçage est utilisé sous une forme à haut degré de pureté avec une concentration maximale d'impuretés inférieure ou égale à l'impureté du gaz de procédé.

11. Procédé selon l'une des revendications 5 à 10,
**caractérisé en ce que**
le gaz de procédé est utilisé pour la purification par plasma de la chambre de réaction (1).

12. Procédé selon l'une des revendications 5 à 11,
**caractérisé en ce que**
comme gaz de procédé on utilise SiH₄, H₂, O₂, N₂O, CO₂, He, TiCl₄. SiCl₄, NF₃, SF₆, CF₄, CCl₄ ou des mélanges de ceux-ci.
